# EUROPÄISCHE PATENTSCHRIFT

(11) **EP 2 252 753 B1**
(45) Veröffentlichungstag und Bekanntmachung des Hinweises auf die Patenterteilung: **25.07.2012**
(21) Anmeldenummer: 09719009.4
(22) Anmeldetag: 30.01.2009
(51) Int. Cl.: E05B 65/20

(54) **KRAFTFAHRZEUG-TÜRAUSSENGRIFF MIT EINEM SENSORMODUL**
MOTOR VEHICLE OUTSIDE DOOR HANDLE WITH A SENSOR MODULE
POIGNÉE EXTÉRIEURE DE PORTIÈRE DE VÉHICULE ÉQUIPÉE D UN MODULE DE DÉTECTION

(30) Priorität: 13.03.2008 DE 102008000650
(43) Veröffentlichungstag der Anmeldung: 24.11.2010
(73) Patentinhaber: Huf Hülsbeck & Fürst GmbH & Co. KG, 42551 Velbert (DE)
(72) Erfinder: PESCHL, Andreas, 45249 Velbert (DE); NEUHOFF, Stefan, 45239 Essen (DE); KILIAN, Marion, 42551 Velbert (DE)
(74) Vertreter: Zenz
(86) Internationale Anmeldenummer: PCT/EP2009/051087
(87) Internationale Veröffentlichungsnummer: WO 2009/112310

(56) Entgegenhaltungen:
- WO-A-02/33203
- WO-A-2005/008003
- WO-A-2008/107046

## Beschreibung

Die Erfindung betrifft einen Kraftfahrzeug-Türaußengriff mit einer einen Innenraum umgebenden Wandung, einer ersten Sensorelektrode eines ersten kapazitiven Sensors zum Auslösen eines Entriegelungsvorgangs bei Erfassung einer Annäherung eines Bedienerkörperteils an einen zwischen dem Türaußengriff und einer Türwandung gebildeten Raum, insbesondere bei Erfassung eines Eindringens eines Bedienerkörperteils in einem zwischen dem Türaußengriff und einer Türwandung gebildeten Zwischenraum, einer zweiten Sensorelektrode eines zweiten kapazitiven Sensors zum Auslösen eines Verriegelungsvorgangs bei Erfassung der Annäherung eines Bedienerkörperteils an eine vorgegebene Stelle an einer von der Türwandung abgewandten Außenfläche des Türaußengriffs und einer mit der Sensorelektrode und der zweiten Sensorelektrode verbundenen und in dem Innenraum angeordneten Auswerteschaltung, wobei die erste Sensorelektrode, die zweite Sensorelektrode und die Auswerteschaltung in einem einzigen in den Innenraum einsetzbaren Sensormodul untergebracht sind, und die Sensorelektroden von Metallisierungsschichten der Leiterplatte oder von auf der Leiterplatte montierten Metallkörpern gebildet sind, wobei die Metallflächen der Sensorelektroden auf nebeneinander angeordneten Leiterplattenbereichen angeordnet sind und/oder zumindest eine Metallfläche beabstandet von der Leiterplatte angeordnet ist.

Bei bekannten Kraftfahrzeug-Türaußengriffen der eingangs genannten Art, die beispielsweise aus der WO 02/33203 A bekannt sind, handelt es sich bei der ersten Sensorelektrode üblicherweise um eine Metallplatte oder Metallfolie, die in dem Türgriff in der Nähe der nach innen (das heißt zur Wandung der Tür) weisenden Fläche des Türgriffs angeordnet ist. Diese Sensorelektrode ist über Zuleitungen mit einer Leiterplatte verbunden, auf der Bauelemente einer Auswerteelektronik angeordnet sind. Mit der Leiterplatte ist über Zuleitungen ferner ein zweiter Sensor verbunden, der einen Annäherung eines Fingers des Bedieners an eine vorgegebene Stelle an einer Außenfläche des Türgriffs, insbesondere eine Berührung dieser vorgegebenen Stelle, erfasst, um bei Erfassung dieser Annäherung, insbesondere Berührung, einen Verriegelungsvorgang auszulösen. Der den Verriegelungsvorgang auslösende Sensor kann auch direkt auf der Leiterplatte montiert sein. Bei diesem Sensor kann es sich beispielsweise um einen piezoelektrischen Sensor, eine Taste oder einen kapazitiven Sensor handeln. Bei bekannten Anordnungen, die hier einen kapazitiven Sensor verwenden, ist die Metallelektrode dieses kapazitiven Sensors hinter einem abgedünnten Bereich der Wandung des Türgriffs angeordnet. Hierbei ist es möglich, dass sich ein Feuchtefilm zwischen der Metallelektrode und der Innenfläche der Türgriffwandung ausbildet, der die Empfindlichkeit des Sensors negativ beeinflusst.

Bei bekannten Türgriff-Anordnungen werden die die Bauelemente tragende Leiterplatte und die mit ihr über Zuleitung verbundenen Sensorflächen zunächst in einen Innenraum des Türgriffs eingeschoben. Dann wird der Innenraum mit einer Vergussmasse gefüllt. Dies erfolgt über eine Öffnung an einer Stirnseite des Türgriffs, so dass die Vergussmasse in Türgriff-Längsrichtung in den Innenraum des Türgriffs fließt. Diese Montage ist relativ aufwendig.

Ausgehend von dem genannten Stand der Technik liegt der Erfindung die Aufgabe zugrunde, die Herstellung eines Kraftfahrzeug-Türaußengriffs der eingangs genannten Art zu vereinfachen. Diese Aufgabe wird erfindungsgemäß durch einen Kraftfahrzeug-Türaußengriff mit den Merkmalen des Anspruchs 1 gelöst.

Erfindungsgemäß ist der Kraftfahrzeug-Türaußengriff der eingangs genannten Art dadurch gekennzeichnet, dass das Sensormodul eine flache, eine Bodenwandung aufweisende, einseitig offene Kunststoffwanne aufweist, wobei in die Kunststoffwanne eine mit Anschlusskabeln versehene Leiterplatte eingelegt und die Kunststoffwanne mit einer Kunststoffmasse ausgegossen ist, und dass das Sensormodul derart im Innenraum des Türaußengriffs angeordnet ist, dass ein nach außen vorstehender Wandungsabschnitt der Bodenwandung der Kunststoffwanne des Sensormoduls eine Aussparung in der Wandung des Türaußengriffs durchgreift und dabei die vorgegebene Stelle zum Auslösen des Verriegelungsvorgangs definiert. Das "Ausgießen" soll hier ganz allgemein ein Füllen der die Leiterplatte und Bauelemente umgebenden Zwischenräume in der Kunststoffwanne bezeichnen, beispielsweise durch Schwerkraft-Gießen oder Spitzgießen. Die Sensorelektroden sind von Metallisierungsschichten der Leiterplatte oder von auf der Leiterplatte montierten Metallkörpern gebildet, wobei die Metallflächen der Sensorelektroden auf nebeneinander angeordneten Leiterplattenbereichen angeordnet sind und/oder zumindest eine Metallfläche beabstandet von der Leiterplatte angeordnet ist. Das Auslösen eines Entriegelungsvorgangs im Sinne der Erfindung soll auch Teilvorgänge des Entriegelungsvorgangs, so beispielsweise das Auslösen einer Berechtigungsabfrage, umfassen. Gleiches gilt für das Auslösen des Verriegelungsvorgangs. Die Maßnahme, dass ein nach außen vorstehender Wandungsabschnitt der Bodenwandung der Kunststoffwanne des Sensormoduls eine Aussparung in der Wandung des Türaußengriffs durchgreift und dabei die vorgegebene Stelle zum Auslösen des Verriegelungsvorgangs definiert, trägt insbesondere zur Erhöhung der Zuverlässigkeit bei, weil der vorstehende Wandungsabschnitt, der nach außen die Wandung des Türaußengriffs durchgreift, unmittelbar die von dem Bediener zu berührende Betätigungsfläche des den Verriegelungsvorgang auslösenden Sensors bildet. Innerhalb des Sensormoduls kann sich kein Feuchtefilm ausbilden und der auf der Außenfläche der Bodenwandung des Sensormoduls sich gegebenenfalls ausbildende ) Feuchtefilm wird unmittelbar durch das Körperteil des Bedieners weggewischt oder so weit verdrängt, dass eine sichere Erfassung der Berührung möglich wird. Ein dauerhaftes Verbleiben eines störenden Feuchtigkeitsfilms zwischen der Berührungsfläche und der Sensorelektrode ist nicht mehr möglich.

Die Unterbringung aller Sensor-Komponenten in dem kompakten Sensormodul und die Art der Ausbildung des Sensormoduls gestatten eine einfache Herstellung, da dass Vergießen der Schaltung einfach durch Ausgießen der Kunststoffwanne möglich ist; außerdem ist der Vorgang des Ausgießens einer einseitig offenen Kunststoffwanne schneller als das bekannte Ausgießen des Türgriffs in Längsrichtung ausführbar. Darüber hinaus ermöglicht das Sensormodul eine höhere Zuverlässigkeit, weil die offene Seite der Kunststoffwanne die einzige hinsichtlich einer Undichtheit gefährdete Oberfläche darstellt.

Eine bevorzugte Weiterbildung ist dadurch gekennzeichnet, dass die erste Sensorelektrode von einem auf der Leiterplatte montierten ersten Metallkörper oder von einer Metallisierungsschicht der Leiterplatte gebildet ist, dass auf der Leiterplatte Bauelemente der Auswerteschaltung und ein als zweite Sensorelektrode dienender zweiter Metallkörper montiert sind, und dass der zweite Metallkörper von der Leiterplatte beabstandet in eine den Abmessungen des zweiten Metallkörpers angepasste Vertiefung der Bodenwandung der Kunststoffwanne hineinragt. Dies hat den Vorteil, dass ein Wegrücken der zweiten Sensorelektrode von der ersten Sensorelektrode und somit die getrennte Erfassung des Ansprechens der Sensoren erleichtert wird, und dass die zweite Sensorelektrode näher an die Oberfläche an der Betätigungsstelle herangerückt werden kann, so dass eine geringere Empfindlichkeit des zweiten Sensors einstellbar ist.

Eine bevorzugte Weiterbildung dieser Ausführungsform ist dadurch gekennzeichnet, dass die erste Sensorelektrode von einem auf der Leiterplatte montierten ersten Metallkörper oder von einer Metallisierungsschicht der Leiterplatte gebildet ist, dass auf der Leiterplatte Bauelemente der Auswerteschaltung und ein als zweite Sensorelektrode dienender zweiter Metallkörper montiert sind, und dass der zweite Metallkörper von der Leiterplatte beabstandet in eine den Abmessungen des zweiten Metallkörpers angepasste Vertiefung der Bodenwandung der Kunststoffwanne hineinragt, wobei die den zweiten Metallkörper aufnehmende Vertiefung benachbart zu dem nach außen vorstehenden Wandungsabschnitt des Sensormoduls angeordnet ist. Vorzugsweise weist der zweite Metallkörper einen ebenen Blechabschnitt, der in der Vertiefung flach an einer ebenen Innenfläche der Bodenwandung anliegt. Dann bestimmt die Dicke der Bodenwandung in diesem Bereich den Abstand zwischen der Sensor-Metallfläche und dem Finger des Bedieners beim Betätigen des Verriegelungssensors.

Eine bevorzugte Weiterbildung des Kraftfahrzeug-Türaußengriffs ist dadurch gekennzeichnet, dass die erste Sensorelektrode von einer Metallisierungsschicht auf einer ersten Oberfläche der Leiterplatte gebildet ist und dass die Bauelemente der Auswerteschaltung auf der gegenüberliegenden zweiten Oberfläche der Leiterplatte montiert sind. Dies gestattet eine geringere Baugröße des Sensormoduls. Vorzugsweise ist hierbei die zweite Oberfläche der Leiterplatte der Bodenwandung der Kunststoffwanne zugewandt. Somit ist dann die die erste Sensorelektrode tragende erste Oberfläche der Leiterplatte unmittelbar unter der Oberfläche der Vergussmasse auf der offenen Seite der Kunststoffwanne angeordnet. Der Bauraum, in dem sich die Bauelemente der Auswerteschaltung befinden, führt zu einer Beabstandung der auf der Leiteplatte angeordnete ersten Sensorelektrode von der auf der Seite der Bauelemente in der Vertiefung der Bodenwandung angeordneten zweiten Sensorelektrode und somit zu einer Entkopplung.

Eine bevorzugte Weiterbildung des Kraftfahrzeug-Türaußengriffs ist dadurch gekennzeichnet, dass die Leiterplatte zwei im montierten Zustand des Sensormoduls in Grifflängsrichtung hintereinander in der Kunststoffwanne angeordnete Leiterplattenabschnitte aufweist, wobei ein Leiterplattenabschnitt die als erste Sensorelektrode dienende Metallisierungsschicht und der zweite Leiterplattenabschnitt die Bauelemente der Auswerteschaltung und den zweiten Metallkörper trägt. Auch dies führt zu einem größeren Abstand zwischen den beiden Sensorelektroden, was eine bessere Auswertung und Differenzierung der durch die Sensorelektroden erfassten Kapazitätsänderungen gestattet. Vorzugsweise sind die Bauelemente der Auswerteschaltung derart auf der zweiten Oberfläche der Leiterplatte montiert, dass sie zumindest teilweise von dem zweiten Metallkörper überdeckt sind. Dies gestattet eine geringere Baugröße des Sensormoduls.

Vorzugsweise weist der zweite Metallkörper ein am Boden der Vertiefung anliegendes Blech auf, wobei sich zwischen diesem Blech und der Leiterplatte der Bauraum für die Bauelemente befindet, wobei in dem benachbarten Leiterplattenabschnitt die die erste Sensorelektrode bildende Metallisierungsschicht angeordnet ist.

Bei einer bevorzugten Ausführungsform ist die Wandung des Türaußengriffs in zwei sich in Griffslängsrichtung erstreckende Griffhalbschalen unterteilt, zwischen denen das Sensormodul montiert ist. Die Aussparung der Wandung des Türaußengriffs zur Aufnahme des vorstehenden Wandungsabschnitts des Sensormoduls wird hierbei vorzugsweise von zwei Aussparungshälften der beiden Griffhalbschalen gebildet.

Vorteilhafte und/oder bevorzugte Weiterbildungen der Erfindung sind in den Unteransprüchen gekennzeichnet.

Im Folgenden wird die Erfindung anhand eines in den Zeichnungen dargestellten bevorzugten Ausführungsbeispiels näher erläutert. In den Zeichnungen zeigen:
Figur 1 eine Explosivdarstellung einer Ausführungsform des erfindungsgemäßen Kraftfahrzeug-Türaußengriffs und
Figur 2 eine schematische Schnittansicht des Sensormoduls.

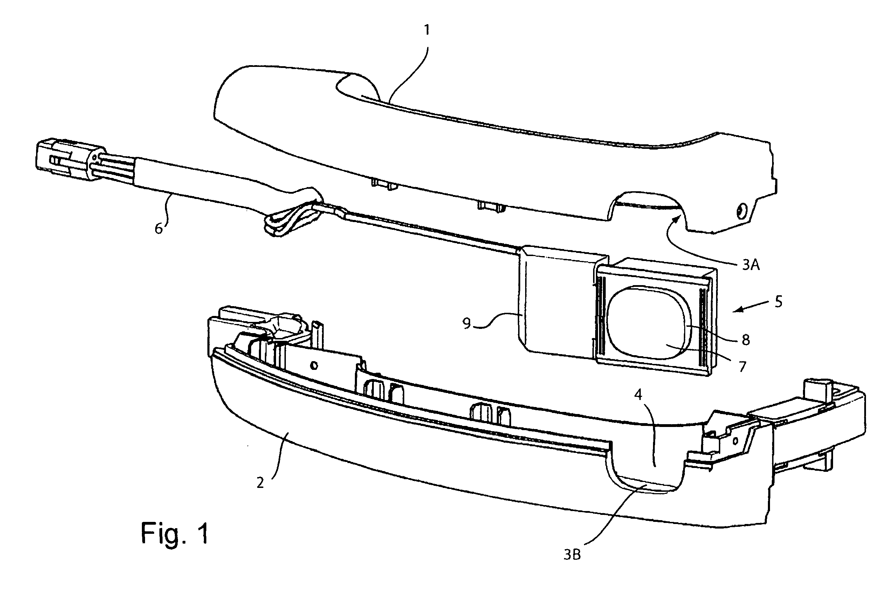

Bei dem in Figur 1 gezeigten bevorzugten Ausführungsbeispiel des erfindungsgemäßen Kraftfahrzeug-Türaußengriffs ist ein Sensormodul 5 in einen Innenraum 4 zweier Griffhalbschalen 1, 2 eingesetzt. Mit dem Sensormodul 5 verbundene Zuleitungsdrähte 6 sind durch den Innenraum 4 innerhalb der Griffhalbschalen 1 und 2 derart geführt, dass sie hinter einer (in Figur 1 nicht dargestellten) Türwandung im Inneren einer Kraftfahrzeugtür aus dem Griff heraustreten. Dort werden die Zuleitungsdrähte 6 mit einer (ebenfalls nicht dargestellten) Spannungsversorgung und Steuereinrichtung gekoppelt.

Das Sensormodul 5 besteht aus einer zu der in Figur 1 nicht sichtbaren Seite hin offenen Kunststoffwanne 9, in welcher eine erste Sensorelektrode eines ersten kapazitiven Sensors (zum Auslösen eines Entriegelungsvorgangs bei Erfassung eines Eindringens eines Bedienerkörperteils in einen zwischen dem Türaußengriff und einer Türwandung gebildeten Zwischenraum), eine zweite Sensorelektrode eines zweiten kapazitiven Sensors (zum Auslösen eines Verriegelungsvorgangs bei Erfassung der Annäherung eines Bedienerkörperteils an eine vorgegebene Stelle an einer von der Türwandung abgewandten Außenfläche des Türaußengriffs) und eine mit der ersten und der zweiten Sensorelektrode verbundene Auswerteschaltung eingebracht sind. Die erste Sensorelektrode befindet sich in dem Sensormodul 5 in der Nähe der in Figur 1 nicht sichtbaren offenen Seite der Kunststoffwanne 9. Nach dem Einbau des Sensormoduls 5 in die Griffhalbschalen 1 und 2 ist die erste Sensorelektrode zum Auslösen des Entriegelungsvorgangs somit in der Nähe der Innenflächen des Türaußengriffs angeordnet. Die zweite Sensorelektrode für den den Verriegelungsvorgang auslösenden Sensor befindet sich unmittelbar hinter einem vorstehenden Wandungsabschnitt 8 der Bodenwandung der Kunststoffwanne 9 des Sensormoduls 5. Das Sensormodul 5 ist so in den Griffhalbschalen 1, 2 montiert, dass der vorstehende Abschnitt 8 der Bodenwandung der Kunststoffwanne 9 eine Öffnung durchgreift, die aus den beiden Teilaussparungen 3A und 3B der Griffhalbschalen 1, 2 gebildet wird. Dadurch befindet sich die Oberfläche 7 des Sensormoduls 5 unmittelbar an der Außenfläche des Kraftfahrzeugtürgriffs.

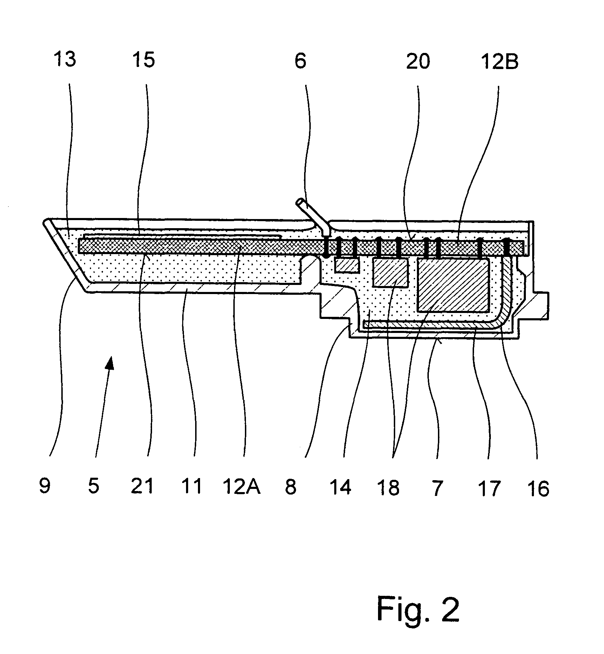

Figur 2 zeigt eine schematische Schnittansicht durch das Sensormodul 5. Das Sensormodul 5 weist eine Kunststoffwanne 9 auf, in der sowohl eine erste Sensorelektrode als auch eine zweite Sensorelektrode und zugehörige Auswerteschaltungen untergebracht sind. In die Kunststoffwanne 9 ist eine Leiterplatte eingelegt, die einen ersten Leiterplattenabschnitt 12A und einen zweiten Leiterplattenabschnitt 12B sowie eine erste Oberfläche 20 und eine der Bodenwandung 11 der Kunststoffwanne 9 zugewandte zweite Oberfläche 21 aufweist. Auf der ersten Leiterplattenoberfläche 20 ist die Metallisierungsschicht im Bereich des ersten Leiterplattenabschnitts 12A derart strukturiert, dass dort eine großflächige erste Sensorelektrode 15 eines kapazitiven Sensors ausgebildet ist. In dem zweiten Leiterplattenabschnitt 12B sind auf der zweiten Leiterplattenoberfläche 21 Bauelemente 18 der Auswerteschaltung aufgebracht. Zusätzlich ist in diesem zweiten Leiterplattenabschnitt 12B ein Metallkörper 16 montiert, der mit einem Metallblechabschnitt 17 einen Teil der Bauelemente 18 überdeckt, wobei der Abschnitt 17 bei dem in Figur 2 dargestellten Ausführungsbeispiel im Wesentlichen parallel zu der Leiterplatte 12A, 12B ausgerichtet ist. Der Metallkörper 16 mit dem Blechabschnitt 17 ragt in eine den Abmessungen des Metallkörpers 16 angepasste Vertiefung 14 der Bodenwandung 11 der Kunststoffwanne 9 hinein. Die Vertiefung 14 der Bodenwandung 11 bildet einen nach außen (in Figur 2 nach unten) vorstehenden Wandungsabschnitt 8 der Kunststoffwanne 9. Der vorstehende Wandungsabschnitt 8 der Kunststoffwanne 9 weist einen ebenen Boden auf, dessen Außenfläche 7 im montierten Zustand des Sensormoduls 5 die Stelle definiert, die von einem Bediener zu berühren ist, um einen Verriegelungsvorgang (Schließvorgang) auszulösen. In der Vertiefung 15 liegt der Blechabschnitt 17 des Metallkörpers 16 im Wesentlichen parallel an der Bodenwandung an. In Abhängigkeit von der Dicke der Bodenwandung ist die Empfindlichkeit des den Teilkörper 16 als Sensorelektrode aufweisenden kapazitiven Sensors so eingestellt, dass dieser Sensor nur dann anspricht, wenn ein Bedienerkörperteil (zum Beispiel ein Finger) die Außenfläche 7 des Sensormoduls 5 berührt. Die Empfindlichkeit des anderen (ersten) kapazitiven Sensors, der die Metallisierungsschicht 15 als Sensorelektrode nutzt, ist höher und so eingestellt, dass mit Hilfe dieses kapazitiven Sensors ein Eingreifen eines Bedienerkörperteils (der Hand) in dem Zwischenraum zwischen dem Türaußengriff und der (in Figur 1 nicht dargestellten) Wandung der Kraftfahrzeugtür erfasst werden kann. Eine Steuerlogik, die beispielsweise teilweise in den Bauelementen 18 der Auswerteschaltung implementiert sein kann, sorgt dafür, dass die Betätigungen des ersten und des zweiten kapazitiven Sensors voneinander unterschieden und sicher erfasst werden können. Bei alternativen Ausführungsformen des Sensormoduls 5 könnte an Stelle der Metallisierungsschicht 15 ein weiterer Metallkörper als Sensorelektrode des ersten kapazitiven Sensors verwendet werden. An Stelle des Metallkörpers 16 des zweiten kapazitiven Sensors könnte am Boden des Sensormoduls 5 auch eine flexible Leiterplatte mit einer Metallisierungsschicht anliegen. Auch könnte die Leiterplatte 12A, 12B selbst flexibel sein. Die Bauelemente 18 der Auswerteschaltung könnten auch im ersten Leiterplattenabschnitt 12A oder in beiden Leiterplattenabschnitten 12A, 12B montiert sein. Bei einer abweichend gestalteten Kunststoffwanne 9 wäre es auch denkbar, dass die von Blechabschnitten gebildeten Sensorelektroden in einem vorgegebenen Winkel zu der Leiterplatte 12A, 12B angeordnet sind.

Die in die Kunststoffwanne 9 des Sensormoduls 5 eingebrachten Bauelemente (12A, 12B, 15, 16, 17, 18) sind von einer Kunststoffmasse 13 umgossen. Das Vergießen der Bauelemente kann bei einer Ausführungsform einfach dadurch realisiert werden, dass eine horizontal in einer Halterung liegende Kunststoffwanne 9 mit eingebrachten Bauelementen von der offenen Oberseite her mit einem flüssigen Kunststoffmaterial gefüllt wird, wobei das Kunststoffmaterial anschließend aushärtet. Alternativ ist es auch denkbar, dass ein Spritzgussverfahren angewendet wird. Vorzugsweise wird die Kunststoffmasse 13 so in die Wanne 9 gefüllt, dass Lufteinschlüsse oder Leerräume vermieden werden.

Bei dem in Figur 2 dargestellten Ausführungsbeispiel sind die erste Sensorelektrode 15 (Metallisierungsschicht des Leiterplattenabschnitts 12A) und die zweite Sensorelektrode 17 (auf dem zweiten Leiterplattenabschnitt 12B montierter Metallkörper 16) in Grifflängsrichtung versetzt angeordnet. Dies hat einerseits den Vorteil, dass die erste Sensorelektrode näher an diejenige Stelle gerückt wird, bei der das Hintergreifen durch die Hand des Bedieners am wahrscheinlichsten ist, so dass die Empfindlichkeit des ersten kapazitiven Sensors verringert werden kann. Zweitens hat dies den Vorteil einer Entkopplung des ersten und des zweiten kapazitiven Sensors. Bei einem alternativen Ausführungsbeispiel könnten jedoch sowohl die erste als auch die zweite Sensorelektrode von jeweils einem Metallkörper gebildet sein, die in demselben Leiterplattenabschnitt, aber auf entgegengesetzten Leiterplattenseiten montiert sind.

## Patentansprüche

1. Kraftfahrzeug-Türaußengriff mit
einer einen Innenraum (4) umgebenden Wandung,
einer ersten Sensorelektrode (15) eines ersten kapazitiven Sensors zum Auslösen eines Entriegelungsvorgangs bei Erfassung einer Annäherung eines Bedienerkörperteils an einen zwischen dem Türaußengriff und einer Türwandung gebildeten Raum,
einer zweiten Sensorelektrode (16) eines zweiten kapazitiven Sensors zum Auslösen eines Verriegelungsvorgangs bei Erfassung einer Annäherung eines Bedienerkörperteils an eine vorgegebene Stelle (7) an einer von der Türwandung abgewandten Außenfläche des Türaußengriffs und
einer mit der ersten Sensorelektrode (15) und der zweiten Sensorelektrode (16) verbundenen und in dem Innenraum (4) angeordneten Auswerteschaltung, wobei
die erste Sensorelektrode (15), die zweite Sensorelektrode (16) und die Auswerteschaltung in einem einzigen in den Innenraum (4) einsetzbaren Sensormodul (5) untergebracht sind, und
die Sensorelektroden (15, 16) von Metallisierungsschichten (15) der Leiterplatte (12A, 12B) oder von auf der Leiterplatte montierten Metallkörpern (16) gebildet sind, wobei die Metallflächen (15, 17) der Sensorelektroden auf nebeneinander angeordneten Leiterplattenbereichen angeordnet sind und/oder zumindest eine Metallfläche beabstandet von der Leiterplatte angeordnet ist,
**dadurch gekennzeichnet,**
**dass** das Sensormodul (5) eine flache, eine Bodenwandung (11) aufweisende, einseitig offene Kunststoffwanne (9) aufweist, wobei in die Kunststoffwanne (9) eine mit Anschlusskabeln (6) versehene Leiterplatte (12A, 12B) eingelegt und die Kunststoffwanne (9) mit einer Kunststoffmasse (13) ausgegossen ist, und
**dass** das Sensormodul (5) derart im Innenraum (4) des Türaußengriffs angeordnet ist, dass ein nach außen vorstehender Wandungsabschnitt (8) der Bodenwandung (11) der Kunststoffwanne (9) des Sensormoduls (5) eine Aussparung (3A, 3B) in der Wandung des Türaußengriffs durchgreift und dabei die vorgegebene Stelle (7) zum Auslösen des Verriegelungsvorgangs definiert.

2. Kraftfahrzeug-Türaußengriff nach Anspruch 1, **dadurch gekennzeichnet,**
**dass** die erste Sensorelektrode (15) von einem auf der Leiterplatte montierten ersten Metallkörper oder von einer Metallisierungsschicht der Leiterplatte (12A, 12B) gebildet ist,
**dass** auf der Leiterplatte (12A, 12B) Bauelemente (18) der Auswerteschaltung und ein als zweite Sensorelektrode dienender zweiter Metallkörper (16) montiert sind, und
**dass** der zweite Metallkörper (16) von der Leiterplatte (12A, 12B) beabstandet in eine den Abmessungen des zweiten Metallkörpers (16) angepasste Vertiefung (14) der Bodenwandung (11) der Kunststoffwanne (9) hineinragt.

3. Kraftfahrzeug-Türaußengriff nach Anspruch 1, **dadurch gekennzeichnet,**
**dass** die erste Sensorelektrode (15) von einem auf der Leiterplatte montierten ersten Metallkörper oder von einer Metallisierungsschicht der Leiterplatte (12A, 12B) gebildet ist,
**dass** auf der Leiterplatte (12A, 12B) Bauelemente (18) der Auswerteschaltung und ein als zweite Sensorelektrode dienender zweiter Metallkörper (16) montiert sind, und
**dass** der zweite Metallkörper (16) von der Leiterplatte (12a, 12B) beabstandet in eine den Abmessungen des zweiten Metallkörpers (16) angepasste Vertiefung (14) der Bodenwandung (11) der Kunststoffwanne (9) hineinragt, wobei die den zweiten Metallkörper (16) aufnehmende Vertiefung (14) benachbart zu dem nach außen vorstehenden Wandungsabschnitt (8) des Sensormoduls (5) angeordnet ist.

4. Kraftfahrzeug-Türaußengriff nach Anspruch 2 oder 3,
**dadurch gekennzeichnet, dass** der zweite Metallkörper einen ebenen Blechabschnitt (17) aufweist, der in der Vertiefung (14) flach an einer ebenen Innenfläche der Bodenwandung (11) anliegt.

5. Kraftfahrzeug-Türaußengriff nach einem der Ansprüche 2, 3 oder 4, **dadurch gekennzeichnet,**
**dass** die erste Sensorelektrode (15) von einer Metallisierungsschicht auf einer ersten Oberfläche (20) der Leiterplatte (12A, 12B) gebildet ist, und
**dass** die Bauelemente (18) der Auswerteschaltung auf der gegenüberliegenden zweiten Oberfläche (21) der Leiterplatte (12A, 12B) montiert sind.

6. Kraftfahrzeug-Türaußengriff nach Anspruch 5, **dadurch gekennzeichnet, dass** die zweite Oberfläche (21) der Leiterplatte (12A, 12B) der Bodenwandung (11) der Kunststoffwanne (9) zugewandt ist.

7. Kraftfahrzeug-Türaußengriff nach Anspruch 6, **dadurch gekennzeichnet, dass** die Leiterplatte zwei im montierten Zustand des Sensormoduls (5) in Grifflängsrichtung hintereinander in der Kunststoffwanne (9) angeordnete Leiterplattenabschnitte (12A, 12B) aufweist, wobei ein Leiterplattenabschnitt (12A) die als erste Sensorelektrode dienende Metallisierungsschicht (15) und der zweite Leiterplattenabschnitt (12B) die Bauelemente der Auswerteschaltung und den zweiten Metallkörper (16) aufweist.

8. Kraftfahrzeug-Türaußengriff nach Anspruch 6 oder 7,
**dadurch gekennzeichnet, dass** die Bauelemente (18) der Auswerteschaltung derart auf der zweiten Oberfläche (21) der Leiterplatte(12A, 12B) montiert sind, dass sie zumindest teilweise von dem zweiten Metallkörper (16) überdeckt sind.

9. Kraftfahrzeug-Türaußengriff nach einem der Ansprüche 1 - 8, **dadurch gekennzeichnet, dass** die Wandung des Türaußengriffs in zwei sich in Grifflängsrichtung erstreckende Griffhalbschalen (1, 2) unterteilt ist, zwischen denen das Sensormodul (5) montiert ist.

## Claims

1. A motor vehicle external door handle including a wall surrounding an internal space (4), a first sensor electrode (15) of a first capacitive sensor for initiating an unlocking process on detection of the approach of a body portion of a user to a space defined between the external door handle and a door wall, a second sensor electrode (16) of a second capacitive sensor for initiating a locking process on detection of the approach of a body portion of a user to a predetermined position (7) on an external surface of the external door handle remote from the door wall and an analysis circuit connected to the first sensor electrode (15) and the second sensor electrode (16) and arranged in the internal space (4), wherein the first sensor electrode (15), the second sensor electrode (16) and the analysis circuit are accommodated in a single sensor module (5) insertable into the internal space (4) and the sensor electrodes (15, 16) are constituted by metallisation layers (15) on the circuit board (12A, 12B) or by metal bodies (16) mounted on the circuit board, wherein the metal surfaces (15, 17) of the sensor electrodes are arranged on regions of the circuit board next to one another and/or at least one metal surface is disposed at a distance from the circuit board, **characterised in that** the sensor module (5) includes a flat plastic shell (9), which includes a base wall (11) and is open on one side, wherein a circuit board (12A, 12B) provided with connecting cables (6) is inserted into the plastic shell (9) and the plastic shell (9) is filled with a plastic composition (13) and that the sensor module (5) is so arranged in the internal space (4) of the external door handle that an outwardly projecting wall section (8) of the base wall (11) of the plastic shell (9) of the sensor module (8) passes through an opening (3A, 3B) in the wall of the external door handle and thus defines the predetermined position (7) for initiating the locking process.

2. A motor vehicle external door handle as claimed in claim 1, **characterised in that** the first sensor electrode (15) is constituted by a first metal body mounted on the circuit board or by a metallisation layer on the circuit board (12A, 12B), that components (18) of the analysis circuit and a second metal body (16) serving as the second sensor electrode are mounted on the circuit board (12A, 12B) and that the second metal body (16) is spaced from the circuit board (12A, 12B) and projects into a recess (14), which is matched to the dimensions of the second metal body (16), in the base wall (11) of the plastic shell (9).

3. A motor vehicle external door handle as claimed in claim 1, **characterised in that** the first sensor electrode (15) is constituted by a first metal body mounted on the circuit board or by a metallisation layer on the circuit board (12A, 12B), that components (18) of the analysis circuit and a second metal body (16) serving as the second sensor electrode are mounted on the circuit board (12A, 12B) and that the second metal body (16) is spaced from the circuit board (12A, 12B) and projects into a recess (14) which is matched to the dimensions of the second metal body (16), in the base wall (11) of the plastic shell (9), wherein the recess (14) accommodating the second metal body (16) is disposed adjacent to the outwardly projecting wall section (8) of the sensor module (5).

4. A motor vehicle external door handle as claimed in claim 2 or 3, **characterised in that** the second metal body has a flat section (17) of metal sheet, which engages flat against a smooth inner surface of the base wall (11) within the recess (14).

5. A motor vehicle external door handle as claimed in one of claims 2, 3 or 4, **characterised in that** the first sensor electrode (15) is constituted by a metallisation layer on a first surface (20) of the circuit board (12A, 12B) and that the components (18) of the analysis circuit are mounted on the opposing second surface (21) of the circuit board (12A, 12B).

6. A motor vehicle external door handle as claimed in claim 5, **characterised in that** the second surface (21) of the circuit (12A, 12B) is directed towards the base wall (11) of the plastic shell (9).

7. A motor vehicle external door handle as claimed in claim 6, **characterised in that** the circuit board has two circuit board sections (12A, 12B) arranged behind one another in the plastic shell (9) in the longitudinal direction of the handle in the mounted state of the sensor module (5), wherein one circuit board section (12A) has the metallisation layer (15) serving as the first sensor electrode and the second circuit board section (12B) has the components of the analysis circuit and the second metal body (16).

8. A motor vehicle external door handle as claimed in claim 6 or 7, **characterised in that** the components (18) of the analysis circuit are mounted on the second surface (21) of the circuit board (12A, 12B) such that they are at least partially covered by the second metal body (16).

9. A motor vehicle external door handle as claimed in one of claims 1-8, **characterised in that** the wall of the external door handle is divided into two handle half shells (1, 2) extending in the longitudinal direction of the handle, between which the sensor module (5) is mounted.

## Revendications

1. Poignée extérieure de porte de véhicule automobile comprenant
une paroi entourant une cavité intérieure (4),
une première électrode de capteur (15) d'un premier capteur capacitif servant à déclencher un processus de déverrouillage lorsqu'est détecté le fait qu'une partie de corps d'utilisateur s'approche d'un espace formé entre la poignée extérieure de porte et une paroi de porte,
une seconde électrode de capteur (16) d'un second capteur capacitif servant à déclencher un processus de déverrouillage lorsqu'est détecté le fait qu'une partie de corps d'utilisateur s'approche d'un emplacement préfixé (7) situé sur une surface extérieure de la poignée extérieure de porte, laquelle surface extérieure fait face à l'opposé de la paroi de porte, et
un circuit d'exploitation relié à la première électrode de capteur (15) et à la seconde électrode de capteur (16), et disposé dans la cavité intérieure (4), dans lequel
la première électrode de capteur (15), la seconde électrode de capteur (16) et le circuit d'exploitation sont disposés dans un module de capteur (5) unique placé dans la cavité intérieure (4), et
les électrodes de capteur (15, 16) sont formées de couches de métallisation (15) de la plaquette de circuit imprimé (12A, 12B) ou de corps métalliques (16) montés sur la plaquette de circuit imprimé, les surfaces métalliques (15, 17) des électrodes de capteur étant disposées sur des zones de la plaquette de circuit imprimé situées l'une à côté de l'autre et/ou au moins une surface métallique étant disposée à distance de la plaquette de circuit imprimé,
**caractérisée**
**en ce que** le module de capteur (5) comprend une cuvette (9) en matière plastique, plate, ouverte d'un côté et présentant une paroi de fond (11), une plaquette de circuit imprimé (12A, 12B) pourvue de câbles de raccordement (6) étant logée dans la cuvette (9) en matière plastique et la cuvette (9) étant remplie d'une masse (13) de matière plastique, et
**en ce que** le module de capteur (5) est disposé dans la cavité intérieure (4) de la poignée extérieure de porte de façon telle qu'une partie de paroi (8), en saillie vers l'extérieur, de la paroi de fond (11) de la cuvette (9) en matière plastique du module de capteur (5) passe à travers un évidement (3A, 3B) ménagé dans la paroi de la poignée extérieure de porte et définit ainsi l'emplacement préfixé (7) servant au déclenchement du processus de déverrouillage.

2. Poignée extérieure de porte de véhicule automobile suivant la revendication 1, **caractérisée**
**en ce que** la première électrode de capteur (15) est formée d'un premier corps métallique monté sur la plaquette de circuit imprimé ou d'une couche de métallisation de la plaquette de circuit imprimé (12A, 12B),
**en ce que** sont montés sur la plaquette de circuit imprimé (12A, 12B) des composants (18) du circuit d'exploitation et un second corps métallique (16) servant de seconde électrode de capteur, et
**en ce que** le second corps métallique (16) fait saillie, à distance de la plaquette de circuit imprimé (12A, 12 B), dans une partie en renfoncement (14), adaptée aux dimensions du second corps métallique (16), de la paroi de fond (11) de la cuvette (9) en matière plastique.

3. Poignée extérieure de porte de véhicule automobile suivant la revendication 1, **caractérisée**
**en ce que** la première électrode de capteur (15) est formée d'un premier corps métallique monté sur la plaquette de circuit imprimé ou d'une couche de métallisation de la plaquette de circuit imprimé (12A, 12B),
**en ce que** sont montés sur la plaquette de circuit imprimé (12A, 12B) des composants (18) du circuit d'exploitation et un second corps métallique (16) servant de seconde électrode de capteur, et
**en ce que** le second corps métallique (16) fait saillie, à distance de la plaquette de circuit imprimé (12A, 12 B), dans une partie en renfoncement (14), adaptée aux dimensions du second corps métallique (16), de la paroi de fond (11) de la cuvette (9) en matière plastique, tandis que la partie en renfoncement (14) servant à loger le second corps métallique (16) est disposée à proximité de la partie de paroi (8), en saillie vers l'extérieur, du module de capteur (5).

4. Poignée extérieure de porte de véhicule automobile suivant la revendication 2 ou 3, **caractérisée en ce que** le second corps métallique comprend un tronçon de tôle (17) qui est en appui, dans la partie en renfoncement (14), à plat sur une surface intérieure plane de la paroi de fond (11).

5. Poignée extérieure de porte de véhicule automobile suivant l'une des revendications 2, 3 ou 4, **caractérisée**
**en ce que** la première électrode de capteur (15) est formée d'une couche de métallisation sur une première surface (20) de la plaquette de circuit imprimé (12A, 12 B) et
**en ce que** les composants (18) du circuit d'exploitation sont montés sur la seconde surface (21), opposée, de la plaquette de circuit imprimé (12A, 12B).

6. Poignée extérieure de porte de véhicule automobile suivant la revendication 5, **caractérisée en ce que** la seconde surface (21) de la plaquette de circuit imprimé (12A, 12B) fait face à la paroi de fond (11) de la cuvette (9) en matière plastique.

7. Poignée extérieure de porte de véhicule automobile suivant la revendication 6, **caractérisée en ce que** la plaquette de circuit imprimé comprend deux parties de plaquette imprimée (12A, 12B) disposées dans la cuvette (9) en matière plastique, à l'état monté du module de capteur (5), l'une derrière l'autre suivant la direction longitudinale de la poignée, et dans laquelle une partie de plaquette de circuit imprimé (12A) comprend la couche de métallisation (15) servant de première électrode de capteur et la seconde partie de plaquette de circuit imprimé (12B) comprend les composants du circuit d'exploitation et le second corps métallique (16).

8. Poignée extérieure de porte de véhicule automobile suivant la revendication 6 ou 7, **caractérisée en ce que** les composants (18) du circuit d'exploitation sont montés sur la seconde surface (21) de la plaquette de circuit imprimé (12A, 12B) de façon telle qu'ils sont recouverts au moins partiellement par le second corps métallique (16).

9. Poignée extérieure de porte de véhicule automobile suivant l'une des revendications 1 - 8, **caractérisée en ce que** la paroi de la poignée extérieure de porte est divisée en deux demi-coquilles de poignée (1, 2) s'étendant suivant la direction longitudinale de la poignée et entre lesquelles le module de capteur (5) est monté.
